# FASCICULE DE BREVET EUROPEEN

(11) **EP 0 674 475 B1**
(45) Date de publication et mention de la délivrance du brevet: **12.02.1997**
(21) Numéro de dépôt: 95400638.3
(22) Date de dépôt: 22.03.1995
(51) Int. Cl.: H05K 7/18, H02B 1/01, H02B 1/30

(54) **Elément de structure d'un châssis-cadre d'armoire de commutation**
Strukturelement für einen Gestellrahmen eines Schaltschranks
Structural element of a switching cabinet frame

(30) Priorité: 25.03.1994 FR 9403538
(43) Date de publication de la demande: 27.09.1995
(73) Titulaire: GEC ALSTHOM EQUIPEMENTS BASSE TENSION SA, 75116 Paris (FR)
(72) Inventeur: Gudefin, Patrice, F-71880 Chatenoy Le Royal (FR)
(74) Mandataire: Fournier, Michel

(56) Documents cités:
- EP-A- 0 505 681
- DE-A- 1 946 486
- DE-U- 9 213 277

## Description

L'invention porte sur un élément de structure d'un châssis-cadre d'une armoire de commutation électrique destinée au logement d'appareillages électriques ou électroniques comme un disjoncteur.

Un tel élément de structure de châssis-cadre d'armoire de commutation est composé d'un montant, d'une traverse et d'un longeron réalisés sous la forme de tronçons de profilés, éventuellement creux, ayant chacun une paroi définissant une âme de profilé et qui sont assemblés entre eux par des moyens d'assemblage afin de définir un trièdre rectangle.

Dans un châssis-cadre d'une armoire de commutation, on trouve un tel trièdre rectangle aux huit coins de l'armoire.

Il est connu du document FR-A-2683402 un châssis-cadre pour une armoire de commutation qui est composée de tronçons de profilés creux correspondant à un montant, une traverse et un longeron. Dans tous les angles de ce châssis-cadre, il est prévu des éléments d'enfichage harmonisés avec la section transversale intérieure des tronçons de profilés creux qui sont introduits dans les tronçons profilés creux. Les tronçons de profilés creux butent l'un contre l'autre à angles droit. Un des éléments d'enfichage comporte une pièce d'angle. Pour former un trièdre du châssis-cadre, on dispose donc d'un montant équipé de l'élément d'enfichage formé de la pièce d'angle, d'un longeron et d'une traverse équipés chacun d'un élément d'enfichage sans pièce d'angle. Pour l'établissement du trièdre, on introduit l'élément d'enfichage du longeron dans la pièce d'angle de l'élément d'enfichage du montant. Puis on introduit l'élément d'enfichage de la traverse dans la pièce d'angle de l'élément d'enfichage du montant. Et enfin, on fixe les deux éléments d'enfichage du longeron et de la traverse dans la pièce d'angle de l'élément d'enfichage du montant à l'aide d'une vis d'assemblage.

Cet agencement présente les inconvénients suivants.

Les éléments d'enfichage doivent avoir une section complémentaire à la section des tronçons de profilés, laquelle est compliquée.

Si les tronçons de profilés n'ont pas la même section, il faut autant d'éléments d'enfichage différents qu'il y a de section de profilés différentes. Dans le cas inverse, il faut tout de même prévoir de fabriquer trois pièces différentes, en dehors des tronçons de profilés, à savoir, un élément d'enfichage avec pièce d'angle, un élément d'enfichage sans pièce d'angle et une vis.

La liaison élément d'enfichage-tronçon de profilé nécessite une grande précision de fabrication de l'élément d'enfichage et du tronçon de profilé. Il en est de même pour la liaison élément d'enfichage-pièce d'angle.

Cet agencement ne permet pas d'envisager l'assemblage du longeron avec le montant autre part qu'à un coin du châssis-cadre.

Le but de l'invention est de proposer un élément de structure pour un châssis-cadre d'armoire de commutation qui ne présente pas les inconvénients précités et qui comprend un nombre réduit d'éléments différents.

A cet effet, l'invention a pour objet un élément de structure d'un châssis-cadre de mobilier d'atelier, composé d'un montant, d'une traverse et d'un longeron réalisés sous la forme de tronçons de profilés ayant chacun une paroi définissant une âme de profilé et qui sont assemblés entre eux par des moyens d'assemblage afin de définir un trièdre, caractérisé par des moyens d'assemblage comprenant un premier et un second goussets de forme identique et munis chacun d'un moyen d'accrochage destiné à engager des lumières prévues dans l'âme du montant et du longeron, le premier gousset réalisant l'assemblage à angle droit du longeron sur le montant par l'engagement de son moyen d'accrochage dans les lumières du montant et du longeron, le second gousset réalisant l'assemblage à angle droit de la traverse sur le montant et le longeron par engagement de son moyen d'accrochage dans les lumières du montant, et un élément de serrage étant prévu pour solidariser le premier gousset avec le second gousset de manière à rigidifier l'ensemble, cet élément de serrage passant au travers d'un trou prévu dans l'âme de la traverse.

L'invention s'étend à un gousset et à un tronçon de profilé spécialement prévus pour un tel élément de structure ainsi qu'à une armoire de commutation comprenant un tel élément de structure.

Un exemple de réalisation de l'invention est décrit en détail ci-après.

La figure 1 est une vue en perspective de l'élément de structure sur laquelle sont montrés un montant, un longeron, une traverse, deux goussets et une vis.

Les figures 2 et 3 sont des vues en perspective d'un gousset.

La figure 4 est une vue de côté du gousset.

La figure 5 est une vue de dessus du gousset.

La figure 6 est une vue en coupe selon VI-VI du gousset montré à la figure 5.

La figure 7 est une vue en coupe selon VII-VII du gousset montré à la figure 5.

La figure 8 montre en coupe longitudinale un montant.

Les figures 9 et 10 montrent en coupe longitudinale un longeron.

La figure 11 montre en coupe longitudinale une traverse.

Les figures 12 et 13 montrent l'âme et une aile d'un tronçon de profilé adapté pour constituer un montant, un longeron ou une traverse.

Les figures 14 à 17 illustrent l'assemblage d'un montant, d'un longeron et d'une traverse avec des goussets selon l'invention pour définir un trièdre rectangle.

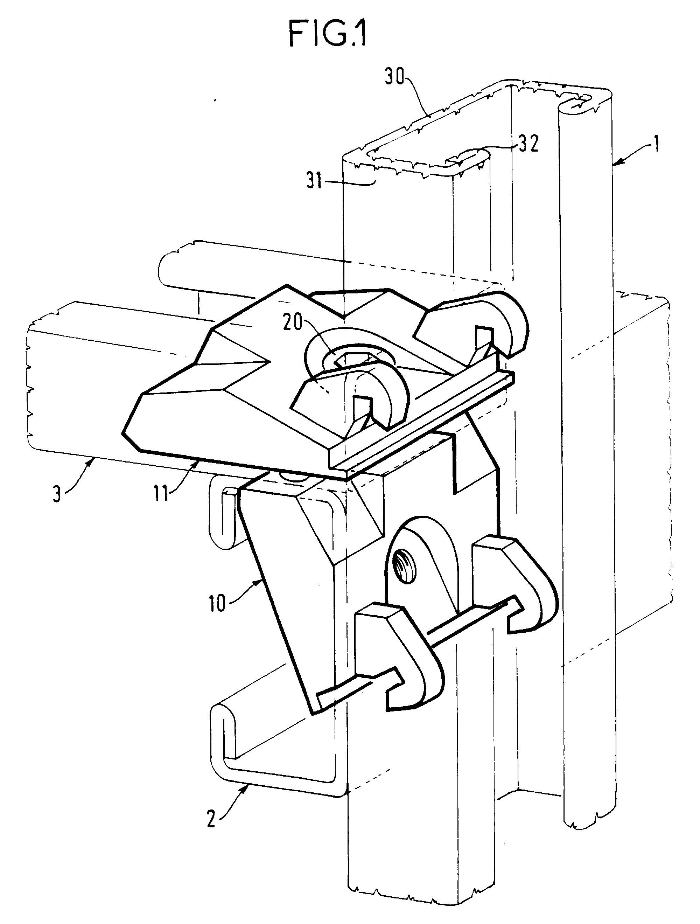

Sur la figure 1, l'élément de structure d'un châssis-cadre d'armoire de commutation comprend un montant 1, un longeron 2 et une traverse 3, un premier gousset 10, un second gousset 11 et une vis 20. Le premier gousset 10 est identique au second gousset 11 dans un but de réduction des coûts de fabrication du châssis-cadre.

Comme visible sur cette figure, le montant, le longeron et la traverse sont réalisés sous la forme de profilés creux à section en U.

La section d'un profilé peut présenter en plus des ailes 32 prolongeant les branches 31 du U vers l'intérieur du profilé. Chaque tronçon de profilé a une paroi plane définissant une âme de profilé indiquée par 30 pour le montant et qui correspond à la base du U.

Il n'est pas nécessaire que le montant, le longeron et la traverse soient formés de tronçons de profilé creux identiques (en section particulièrement). Ainsi le montant, le longeron ou la traverse pourraient simplement se présenter sous la forme de plaques ou de cornières.

Comme cela apparaît sur cette figure, le trièdre rectangle formé par le montant, le longeron et la traverse ne se trouve par à l'extrémité du montant. Il s'ensuit que cet élément de structure peut convenir pour compartimenter le châssis-cadre d'une armoire de commutation à l'intérieur de celle-ci.

Par ailleurs et comme décrit par la suite, si les montants, longerons et traverses d'un châssis-cadre sont issus d'un seul type de profilé, la fabrication d'un tel châssis-cadre ne nécessite de disposer, en dehors du profilé, que d'un gousset en X exemplaires et d'une vis en X/2 exemplaires.

Comme on pourra le comprendre par la suite, le montage de ces différents éléments pour constituer un châssis-cadre d'armoire de commutation est facilité par le fait qu'il peut se faire en aveugle, c'est-à-dire sans qu'il soit nécessaire d'accéder à l'arrière du châssis-cadre de l'armoire de commutation. Il en est de même pour le démontage du châssis-cadre. Ceci est avantageux, lorsque l'arrière du châssis-cadre est destiné à être fixé contre un mur.

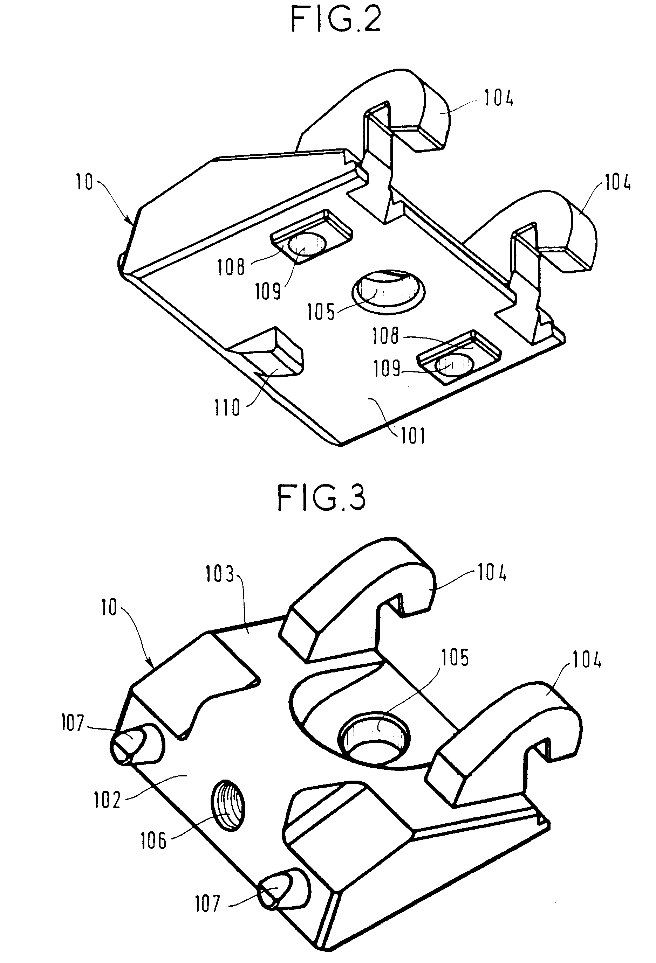

Un exemple de réalisation d'un gousset 10,11 est montré aux figures 2 à 6. Ces goussets 10,11 étant identiques dans leur forme, seul le gousset 10 est décrit ci-après.

Le gousset 10 se présente sous la forme d'une cale d'angle ayant une première face plane de référence 101 visible sur la figure 2, une seconde face plane de référence 102 visible sur la figure 3 et une troisième face plane de référence 103 visible sur la figure 3. La seconde face de référence 102 est sécante avec la première face de référence 101. La troisième face de référence 103 est sécante avec les première et seconde faces de référence et perpendiculaire à la seconde face de référence.

Le gousset 10 comporte aussi deux crochets 104 visibles sur les figures 2 et 3 qui s'étendent parallèlement l'un par rapport à l'autre en faisant saillie par rapport au volume de la cale dans le prolongement des première et troisième faces de référence. Il est entendu que le nombre de crochets est donné ici à titre d'exemple non limitatif.

Le gousset 10 comporte encore un trou lisse 105 visible sur les figures 2 et 3 qui passe au travers des faces de référence 101,103 et un trou fileté 106 visible sur la figure 3 débouchant de la face de référence 102. Le trou lisse 105 a un axe longitudinal 135 perpendiculaire à la face de référence 101 et le trou fileté 106 a un axe longitudinal 136 perpendiculaire à la face de référence 102.

De préférence, il comporte encore deux tenons cylindriques 107 visibles sur la figure 3 faisant saillie par rapport à la seconde surface plane 102 à angle droit et disposés de part et d'autre du trou fileté 106 et deux tenons rectangulaires 108 visibles sur la figure 2 faisant saillie par rapport à la première face de référence 101 et disposés de part et d'autre du trou lisse 105.

Il comporte aussi des trous lisses 109 visibles sur la figure 2 qui débouchent de la face de référence 101 et disposés respectivement sensiblement au milieu des tenons rectangulaires 108. Ces trous lisses 109 sont destinés à recevoir les tenons cylindriques 107 comme décrits ci-après et servent à améliorer l'équerrage entre les tronçons de profilé.

Enfin, il comporte une rampe 110 visible sur la figure 2 faisant saillie par rapport à la face de référence 101.

Les tronçons de profilés constituant le montant, le longeron et la traverse présentent des perçages nécessaires au passage des crochets, des tenons cylindriques et des tenons rectangulaires des goussets ainsi que de la vis.

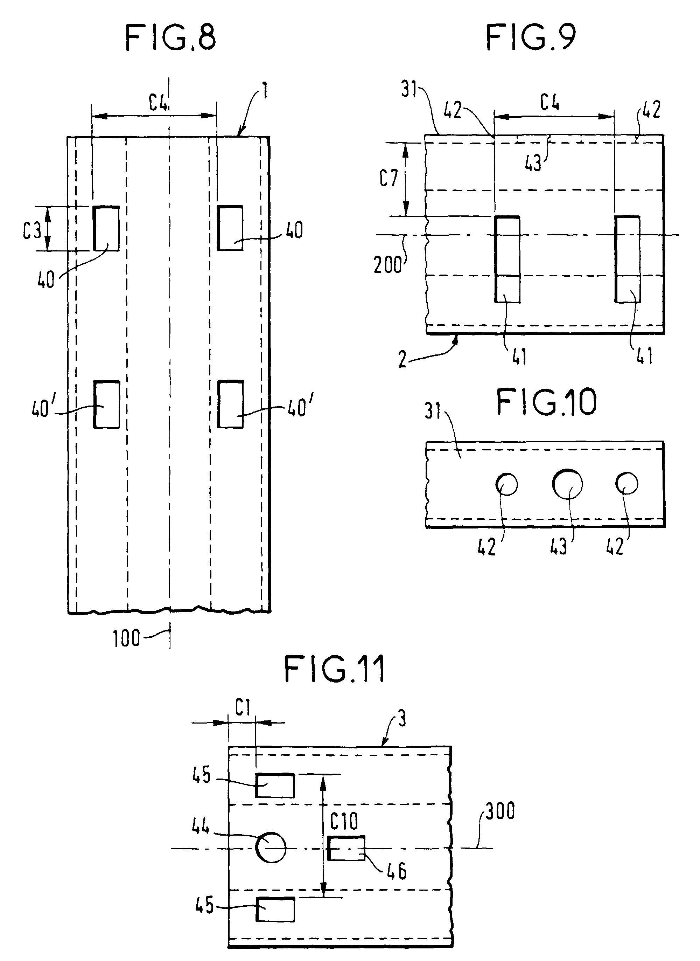

Sur la figure 8, l'âme du montant 1 présente essentiellement deux lumières rectangulaires 40 espacées l'une de l'autre selon une direction transversale par rapport à l'axe longitudinal 100 du montant 1. Ces lumières servent au passage des crochets du premier gousset 10 au travers de l'âme du montant. Comme visible sur cette figure, deux autres lumières 40' sont pratiquées dans l'âme du montant. Ces deux lumières 40' sont décalées axialement par rapport aux lumières 40 et servent au passage des crochets du second gousset 11. D'autres lumières telles que 40,40' peuvent être prévues dans l'âme du montant de manière à réaliser un trièdre non pas à l'extrémité du montant comme c'est le cas avec les lumières 40,40', mais dans une zone du montant éloignée de cette extrémité.

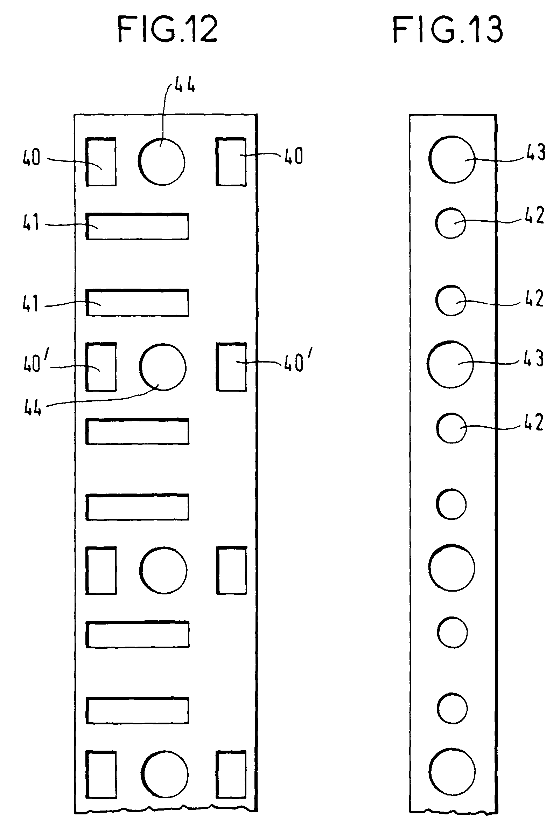

Sur la figure 9, l'âme du longeron 2 présente essentiellement deux lumières rectangulaires 41 espacées l'une de l'autre selon l'axe longitudinal 200 du longeron. Ces lumières servent au passage des crochets du premier gousset 10. D'autres lumières telles que 41' peuvent être pratiquées dans l'âme du longeron de manière à réaliser un trièdre non pas à l'extrémité du longeron comme c'est le cas avec les lumières 41, mais dans une zone du longeron éloignée de cette extrémité. Par ailleurs, sur la figure 10, dans le cas où le longeron comporte une aile 31, celle-ci présente un premier trou 43 servant au passage de la vis 20 et de deux seconds trous 42 alignés axialement avec le premier trou 43 pour le passage des tenons cylindriques du premier gousset 10.

Sur la figure 11, l'âme 30 de la traverse 3 présente deux lumières 45 et un trou 44. Les deux lumières 45 sont situées à l'extrémité de la traverse et sont espacées l'une de l'autre selon une direction transversale par rapport à l'axe 300 longitudinale de la traverse. Le trou 44 est situé entre ces deux lumières. Les lumières 45 servent au passage des tenons rectangulaires du second gousset 11. Le trou 44 sert au passage de la vis 20. L'âme 30 de la traverse présente encore une lumière rectangulaire 46 espacée axialement du trou 44 dans laquelle vient s'introduire la rampe 110 du gousset 11.

Les figures 12 et 13 montrent un tronçon de profilé muni de tous les perçages précités qui sont réalisés dans le montant, le longeron et la traverse. Un tel tronçon de profilé peut donc servir pour former un montant, un longeron ou une traverse ayant des sections respectives identiques. Un tel tronçon de profilé comporte au moins deux premières lumières correspondant aux lumières 40 (éventuellement 45), deux secondes lumières décalées axialement par rapport aux premières lumières et correspondant aux lumières 40', deux troisièmes lumières disposées entre lesdites premières et secondes lumières suivant l'axe longitudinal de l'âme et correspondant aux lumières 41, et au moins un trou entre les deux premières lumières correspondant au trou 44. Si ce tronçon de profilé comporte aussi une aile telle que l'aile 31, il est prévu au moins un trou dans cette aile correspondant au trou 43.

Il est entendu que les perçages 42 et 45 ne sont pas indispensables si le gousset n'est pas muni de tenons cylindriques et de tenons rectangulaires. Il en est de même pour le perçage 46 si le gousset n'est pas muni d'une rampe 110.

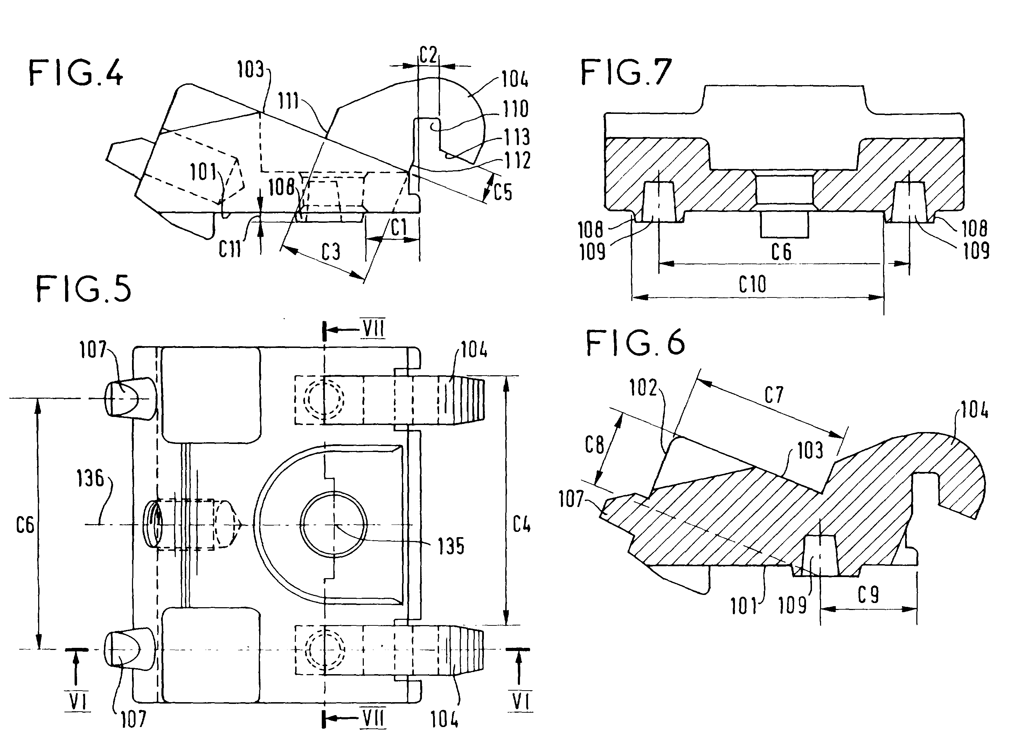

Les côtes importantes du gousset 10 sont mentionnées aux figures 4 à 6. Ces côtes trouvent suivant le cas une correspondance sur les figures 8 à 11 représentant le montant, le longeron et la traverse.

Sur la figure 4, la côte C1 désigne la distance entre le bord avant de la face de référence 101 d'un gousset et le bord avant du tenon rectangulaire 108 de ce gousset. Cette côte C1 correspond sensiblement à la distance entre l'extrémité de la traverse 3 et le bord avant de la lumière 45 visible sur la figure 11 avec un écart de quelques dixièmes de millimètres pour obtenir un effet de traction de la traverse vers le montant comme décrit ci-après.

La côte C2, sur la figure 4, désigne la distance entre le bord avant de la face de référence 101 d'un gousset et la face 110 à l'intérieur d'un crochet 104 du gousset. Cette côte C2 correspond sensiblement à l'épaisseur de l'âme du montant 1 visible à la figure 8 avec un écart de quelques dixièmes de millimètres pour permettre l'engagement d'un crochet du second gousset 11 dans une lumière 40' du montant 1.

La côte C3, sur la figure 4, désigne la distance entre le bord avant 112 et arrière 111 de la base d'un crochet 104. Cette côte C4 correspond sensiblement à la hauteur de la lumière 40 dans le montant 1 visible à la figure 8 de manière telle à permettre l'emboîtement précis avec le moins de jeu possible de la base d'un crochet du premier gousset 10 dans une lumière 40 du montant.

La côte C4, sur la figure 5, désigne la distance entre l'un des côtés latéraux d'un crochet 104 et le côté latéral opposé de l'autre crochet 104 d'un gousset. Cette côte C4 correspond sensiblement à la distance entre un côté latéral d'une lumière 40 dans le montant visible à la figure 8 et le côté latéral opposé de l'autre lumière 40 dans ce montant. La côte C4 correspond encore sensiblement à la distance entre un côté latéral d'une lumière 41 dans le longeron visible à la figure 9 et le côté latéral opposé de l'autre lumière 41 dans ce longeron.

La côte C5, sur la figure 4, désigne la distance entre l'extrémité 113 du crochet 104 d'un gousset et la surface de référence 103 de celui-ci. Cette côte correspond sensiblement à l'épaisseur de l'âme du montant 1 augmentée de l'épaisseur de l'âme du longeron 2 avec un écart de quelques dixièmes de millimètres pour permettre le serrage de l'âme du montant sur l'âme du longeron.

La côte C6, sur la figure 5, désigne la distance entre les axes longitudinaux des tenons cylindriques 107 d'un gousset. Cette côte C6 correspond à la distance entre les axes longitudinaux des trous lisses 109 de ce gousset visibles sur la figure 7 ainsi qu'à la distance entre les milieux respectifs deux trous 42 dans le longeron.

La côte C7, sur la figure 6, désigne la distance entre l'arrière de la base d'un crochet 104 et la face de référence 102 de celui-ci. Cette côte C7 correspond à la distance entre l'extrémité haute de la lumière 41 dans le longeron et l'aile 31 du longeron 2 visible sur les figures 9 et 10.

La côte C8, sur la figure 6, désigne la distance entre l'axe longitudinal d'un tenon cylindrique 107 d'un gousset et la face de référence 103 du gousset. Cette côte C8 correspond à la côte C9 diminuée de l'épaisseur de l'âme du longeron, la côte C9 désignant la distance entre l'extrémité avant de la face de référence 101 d'un gousset et l'axe longitudinal du trou lisse 109 du gousset.

La côte C10, sur la figure 7, désigne la distance entre un bord latéral d'un tenon rectangulaire 108 d'un gousset et le bord latéral opposé de l'autre tenon rectangulaire du gousset. Cette côte C10 correspond sensiblement à la distance entre un côté latéral d'une lumière 45 dans la traverse 3, visible sur la figure 11, et le côté latéral opposé de l'autre lumière 45 dans cette traverse.

La côte C11, sur la figure 4, désigne la hauteur d'un tenon rectangulaire 108 d'un gousset. Cette côte C11 correspond sensiblement à l'épaisseur de l'âme de la traverse avec un écart de quelques dixièmes de millimètres pour le serrage de l'aile 31 du longeron sur l'âme de la traverse.

L'assemblage du montant, du longeron et de la traverse à l'aide d'une paire de goussets et d'une vis est maintenant décrit.

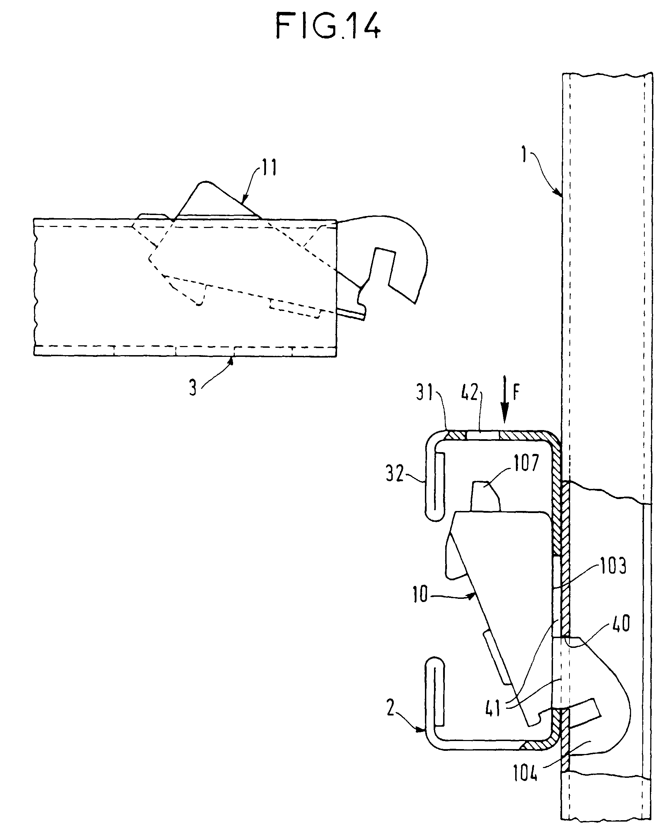

Sur la figure 14, l'âme du longeron 2 est superposée à l'âme du montant 1 de manière telle que le longeron et le montant soient positionnés l'un par rapport à l'autre à angle droit tout en alignant les lumières 41 du longeron avec les lumières 40 du montant.

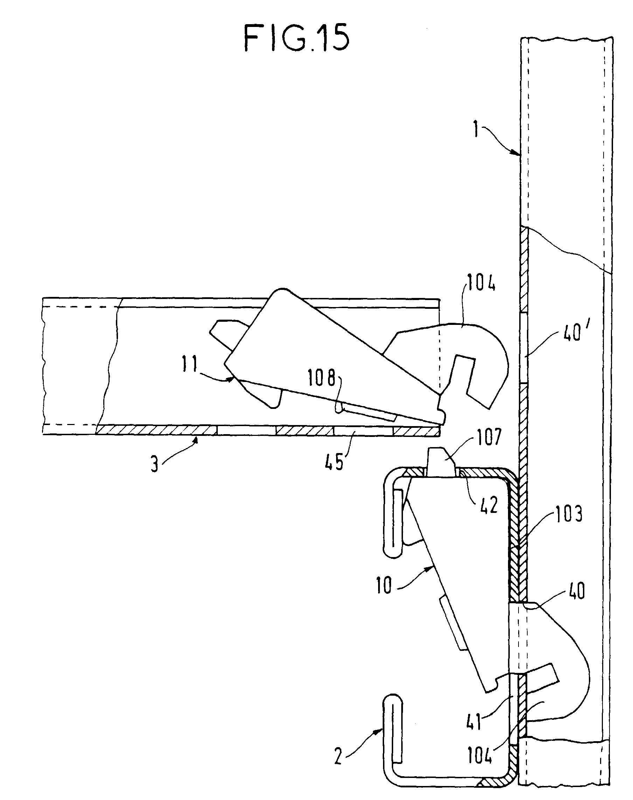

Le premier gousset 10 est mis en place sur l'âme du longeron 2, de manière que les crochets 104 du gousset 10 pénètrent l'âme du longeron et l'âme du montant en engageant les lumières 41,40. Puis la face de référence 103 du gousset 10 est plaquée contre l'âme du longeron 2. Le longeron est ensuite déplacé par rapport au montant selon la direction indiquée par la flèche F. Les tenons cylindriques 107 du gousset 10 s'engagent alors dans les trous 42 de l'aile 31 du longeron comme visible sur la figure 15. Le gousset 10 reste bloqué dans cette position à l'intérieur du longeron grâce à la rampe 110 du gousset 10 qui vient s'appuyer sur l'aile 32 du longeron.

Le longeron et le montant restent solidaires l'un de l'autre grâce à l'action des crochets 104 du gousset 10 qui serrent l'âme du montant sur l'âme du longeron.

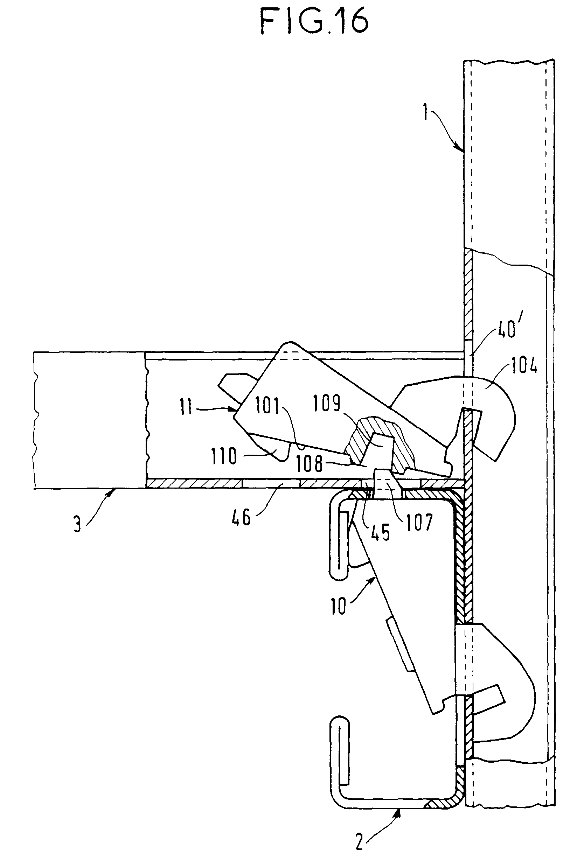

Le second gousset 11 est introduit à l'intérieur de la traverse 3 de manière telle que les crochets 104 du gousset 11 font saillie par rapport à une extrémité de la traverse. Cette extrémité de la traverse 3 est amenée en butée contre l'âme du montant, l'âme de la traverse reposant sur l'aile 31 du longeron de manière que les crochets 104 du second gousset 11 pénètrent l'âme du montant en s'engageant dans les lumières 40' du montant comme visible sur la figure 16.

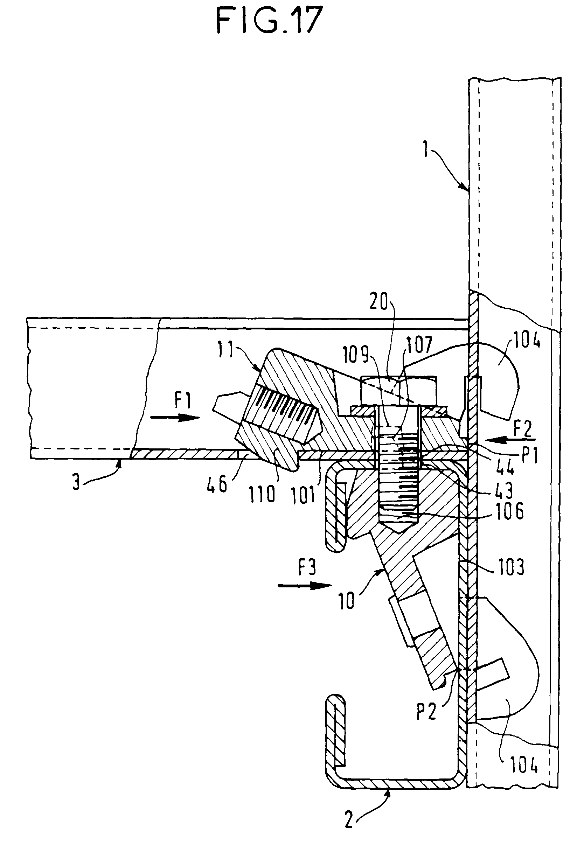

La face de référence 101 du second gousset 11 est ensuite rabattue contre l'âme de la traverse 3 comme visible sur la figure 17. Les tenons cylindriques 107 du premier gousset 10 s'engagent alors dans les trous lisses 109 du second gousset 11. Les tenons rectangulaires 108 du second gousset 11 s'emboîtent à l'intérieur des lumières 45 de la traverse.

L'assemblage final est obtenu par la mise en place de la vis 20 dans le trou lisse 106 du second gousset 11 et le serrage de la vis 20 à l'intérieur du trou fileté 106 dans le premier gousset 10. Le premier gousset 10 devient solidaire du second gousset 11.

Lors du serrage de la vis 20, les tenons rectangulaires 108 du second gousset 11 exercent une force de traction, représentée par la flèche F1 sur la figure 17, ayant pour effet d'entraîner l'extrémité de la traverse 3 contre l'âme du montant 1.

La force F1 s'exerce aussi au point de contact P1 de l'extrémité avant de la face de référence 101 du second gousset 11 sur l'âme du montant 1. En même temps, les crochets 104 du second gousset 11 et l'extrémité avant de la face de référence 101 de celui-ci exercent un couple mécanique dans la zone du point de contact P1. Il en résulte un serrage de l'âme du montant 1 contre l'extrémité de la traverse 3.

Le serrage de la vis 20 dans le trou fileté 106 produit aussi une force de traction, représentée par la flèche F3 ayant pour effet d'entraîner les tenons cylindriques 107 du premier gousset 10 vers le montant 1. En même temps, les crochets 104 du premier gousset 10 et la face de référence 103 de celui-ci exercent un couple mécanique dans la zone du point de contact P2. Il en résulte un serrage de l'âme du longeron 2 contre l'âme du montant 1 et un serrage de l'âme de la traverse 3 contre l'aile 31 du longeron 2 de sorte à obtenir un blocage mutuel entre le montant, le longeron et la traverse pour former un trièdre rectangle.

## Revendications

1. Un élément de structure d'un châssis-cadre d'une armoire de commutation électrique, composé d'un montant (1), d'un longeron (2) et d'une traverse (3) réalisés sous la forme de tronçons de profilés ayant chacun une paroi (30) définissant une âme de profilé et qui sont assemblés entre eux par des moyens d'assemblage afin de définir un trièdre, caractérisé par des moyens d'assemblage comprenant un premier (10) et un second (11) goussets de forme identique et munis chacun d'un moyen d'accrochage (104) destiné à engager des lumières (40,40',41) prévues dans l'âme du montant et du longeron, le premier gousset réalisant l'assemblage à angle droit du longeron sur le montant par l'engagement de son moyen d'accrochage dans les lumières (40,41) du montant et du longeron, le second gousset réalisant l'assemblage à angle droit de la traverse sur le montant et le longeron par engagement de son moyen d'accrochage dans les lumières (40') du montant, et un élément de serrage étant prévu pour solidariser le premier gousset avec le second gousset de manière à rigidifier l'ensemble, cet élément de serrage passant au travers d'un trou (44) prévu dans l'âme de la traverse.

2. L'élément selon la revendication 1, dans lequel le longeron comporte une première aile (31) qui prolonge à angle droit son âme (30), cette aile étant pourvue d'un trou (43) pour le passage de l'élément de serrage (20).

3. L'élément selon la revendication 2, dans lequel le longeron comporte une seconde aile (32) qui prolonge, à l'intérieur du profilé du longeron, la première aile (31) et chaque gousset comporte une rampe (110) qui est destinée à coopérer mécaniquement avec la seconde aile en vue du blocage du gousset dans le longeron.

4. L'élément selon la revendication 1, dans lequel l'élément de serrage (20) est une vis.

5. Un gousset pour un élément de structure selon l'une des revendications 1 à 4, se présentant sous la forme d'une cale d'angle définie par une première face de référence (101), une seconde face de référence (102) sécante avec la première face de référence, une troisième face de référence (103) sécante avec les première et seconde faces de référence et perpendiculaire à la seconde face de référence, deux crochets (104) prolongeant les première et troisième faces de référence, un trou lisse (105) pour le passage d'une vis au travers des première et troisième faces de référence et un trou fileté (106) débouchant de la seconde face de référence, le trou lisse (105) ayant un axe longitudinal (135) perpendiculaire à la première face de référence (101) et le trou fileté (106) ayant un axe longitudinal (136) perpendiculaire à la seconde face de référence (102).

6. Le gousset selon la revendication 5, comprenant en outre des premiers tenons (107) faisant saillie à angle droit sur la seconde face de référence (102), des trous correspondant (109) sur la première face de référence (101) pour recevoir les tenons cylindriques (107) d'un autre gousset, et des seconds tenons (108) sur la première face de référence.

7. Un tronçon de profilé pour un élément de structure selon l'une des revendications 1 à 4, ayant une paroi (30) définissant une âme de profilé ayant un axe longitudinal (100;200;300), cette âme présentant deux premières lumières (40), deux secondes lumières (40') décalées axialement par rapport aux premières lumières, deux troisièmes lumières (41) disposées entre lesdites premières et secondes lumières suivant l'axe longitudinal de l'âme, et au moins un trou (44) entre les deux premières lumières.

8. Le tronçon selon la revendication 7, comportant une aile (31) prolongeant à angle droit l'âme de profilé, cette aile présentant un trou (43).

9. Une armoire de commutation comportant un élément de structure selon l'une des revendications 1 à 4.

## Patentansprüche

1. Strukturelement eines Rahmenchassis für einen elektrischen Schaltschrank, bestehend aus einem aufstrebenden Pfosten (1), einer Längsstrebe (2) und einer Querstrebe (3) in Form von Profilschienen, die je eine eine "Seele" der Schiene definierende Wand (30) besitzen und durch Montagemittel zusammengefügt sind, um ein Dreibein zu definieren, gekennzeichnet durch Montagemittel, die zwei Eckstücke (10, 11) gleicher Form enthalten, welche je ein hakenartiges Mittel (104) aufweisen, wobei dieses Mittel in in der Seele des Pfostens und der Längsstrebe vorgesehene Ausschnitte (40, 40', 41) eindringen soll und das erste Eckstück den rechtwinkligen Zusammenbau der Längsstrebe und des Pfostens durch Eindringen des hakenartigen Mittels in die Ausschnitte (40, 41) des Pfostens und der Längsstrebe bewirkt, während das zweite Eckstück den rechtwinkligen Zusammenbau der Querstrebe mit dem Pfosten und der Längsstrebe durch Eindringen seines hakenartigen Mittels in die Ausschnitte (40') des Pfostens bewirkt, und wobei ein Spannelement vorgesehen ist, um die beiden Eckstücke so fest miteinander zu verbinden, daß die ganze Einheit versteift wird, wobei dieses Spannelement durch ein Loch (44) in der Seele der Querstrebe verläuft.

2. Element nach Anspruch 1, bei dem die Längsstrebe einen ersten Seitenzweig (31) in rechtwinkliger Verlängerung seiner Seele (30) besitzt, der ein Loch (43) für den Durchlaß des Spannelements (20) aufweist.

3. Element nach Anspruch 2, in dem die Längsstrebe einen Flügel (32) besitzt, der den Seitenzweig (31) nach der Innenseite der Längsstrebe verlängert, wobei jedes Eckstück eine Rampe (110) besitzt, die mechanisch mit dem Flügel zu einer Blockierung des Eckstücks in der Längsstrebe zusammenwirkt.

4. Element nach Anspruch 1, in dem das Spannelement (20) eine Schraube ist.

5. Eckstück für ein Strukturelement nach einem der Ansprüche 1 bis 4, in Form eines Winkelkeils, der durch eine erste Bezugsseite (101), eine zweite, die erste Bezugsseite schneidende Bezugsseite (102), eine dritte, die erste und die zweite Bezugsseite schneidende Bezugsseite (103) definiert ist, die zur zweiten Bezugsseite senkrecht verläuft, und zwei die erste und die dritte Bezugsseite verlängernde Haken (104), ein glattes Loch durch die erste und dritte Bezugsseite zum Durchlaß einer Schraube und ein Gewindeloch (106) besitzt, das in der zweiten Bezugsseite mündet, wobei das glatte Loch (105) eine zur ersten Bezugsseite (101) senkrechte Längsachse (135) und das Gewindeloch eine Längsachse (136) besitzt, die zur zweiten Bezugsseite senkrecht verläuft.

6. Eckstück nach Anspruch 5, das außerdem von der zweiten Bezugsseite (102) senkrecht vorstehende zylindrische Zapfen (107), entsprechende Löcher (109) in der ersten Bezugsseite (101) zur Aufnahme der zylindrischen Zapfen (107) eines anderen Eckstücks sowie Nasen (108) auf der ersten Bezugsseite aufweist.

7. Profilschiene für ein Strukturelement nach einem der Ansprüche 1 bis 4 mit einer Wand (30), die eine "Seele" des Schienenprofils mit einer Längsachse (100, 200, 300) definiert, wobei diese Seele zwei erste Ausschnitte (40), zwei zweite Ausschnitte (40'), die axial bezüglich der ersten Ausschnitte versetzt sind, zwei dritte Ausschnitte (41), die zwischen den ersten und den zweiten Ausschnitten in Richtung der Längsachse der Seele liegen, und mindestens ein Loch (44) zwischen den beiden ersten Ausschnitten besitzt.

8. Profilschiene nach Anspruch 7 mit einem Seitenzweig (31), der rechtwinklig die Seele der Schiene verlängert und ein Loch (43) besitzt.

9. Schaltschrank mit einem Strukturelement nach einem der Ansprüche 1 bis 4.

## Claims

1. A structural element of a frame of an electrical switching cabinet, the element being composed of an upright beam (1), of a longitudinal beam (2), and of a cross-beam (3), the beams being implemented in the form of section member segments, each of which has a wall (30) that defines a section member web, and being assembled together by assembly means so as to define a trihedron, said element being characterized by assembly means comprising a first gusset plate (10) and a second gusset plate (11) of identical shape, each of which gusset plates is provided with hook-fastening means (104) designed to engage in slots (40, 40', 41) provided in the web of the upright beam and in the web of the longitudinal beam, the first gusset plate fastening the longitudinal beam to the upright beam at right angles by its hook-fastening means engaging in the slots (40, 41) in the upright beam and in the longitudinal beam, the second gusset plate fastening the cross-beam to the upright beam and to the longitudinal beam at right angles by its hook-fastening means engaging in the slots (40') in the upright beam, and a clamping element being provided for securing the first gusset plate to the second gusset plate so as to stiffen the assembly, which clamping element passes through a hole (44) provided in the web of the cross-beam.

2. A structural element according to claim 1, in which the longitudinal beam is provided with a first flange (31) extending its web (30) at right angles, which flange is provided with a through hole (43) for receiving the clamping element (20).

3. A structural element according to claim 2, in which the longitudinal beam is provided with a second flange (32) which extends the first flange (31) inside the section member of the longitudinal beam, and each gusset plate is provided with a ramp (110) which is designed to co-operate mechanically with the second flange so as to lock the gusset plate in the longitudinal beam.

4. A structural element according to claim 1, in which the clamping element (20) is a screw.

5. A gusset plate for a structural element according to any one of claims 1 to 4, the gusset plate being in the form of an angle block defined by a first reference face (101), a second reference face (102) whose plane intersects the plane of the first reference face, a third reference face (103) whose plane intersects the planes of the first and second reference faces, and is perpendicular to the plane of the second face, two hooks (104) extending the first and third reference faces, a smooth hole (105) for receiving a screw through the first and third reference faces, and a tapped hole (106) opening out in the second reference face, the smooth hole (105) having a longitudinal axis (135) that is perpendicular to the first reference face (101), and the tapped hole (106) has a longitudinal axis (136) that is perpendicular to the second reference face (102).

6. A gusset plate according to claim 5, further including first studs (107) projecting at right angles relative to the second reference face (102), corresponding holes (109) in the first reference face (101) for receiving the cylindrical studs (107) on another gusset plate, and second studs (108) on the first reference face.

7. A section member segment for a structural element according to any one of claims 1 to 4, the section member having a wall (30) defining a section member web having a longitudinal axis (100; 200; 300), which web is provided with two first slots (40), two second slots (40') offset axially relative to the first slots, two third slots (41) disposed between said first and second slots along the longitudinal axis of the web, and at least one hole (44) between the two first slots.

8. A segment according to claim 7, including a flange (31) extending the section member web at right angles, which flange is provided with a hole (43).

9. A switching cabinet including a structural element according to any one of claims 1 to 4.
